# EUROPEAN PATENT APPLICATION

(11) **EP 3 032 661 A1**
(43) Date of publication of application: **15.06.2016**
(21) Application number: 14306985.4
(22) Date of filing: 09.12.2014
(51) Int. Cl.: H01S 5/02, G02B 6/26, H01S 5/026

(54) **Method for manufacturing an optical transmitter by growth of structures on a thin inp buffer bonded onto a silicon based substrate**

(71) Applicant: ALCATEL LUCENT, 92100 Boulogne-Billancourt (FR); Commissariat à l'Energie Atomique et aux Energies Alternatives, 75015 Paris (FR)
(72) Inventor: Gentner, Jean-Louis, 91460 MARCOUSSIS (FR); Decobert, Jean, 91460 MARCOUSSIS (FR)
(74) Representative: Novagraaf Technologies

(57) **Abstract**

A method is intended for manufacturing an optical transmitter (8) comprising structures (7₁-7₆) defining together transmission means. This method comprises a first step in which an InP wafer (3) is bonded on a substrate (1) comprising silicon, then this InP wafer (3) is made thinner to become an InP buffer (4), a second step in which a dielectric mask is laid onto this InP buffer (4), then openings (6) are patterned into chosen locations of this dielectric mask, and a third step in which the structures (7₁-7₆) are grown into corresponding patterned openings (6), then remaining parts of the dielectric mask are removed.

## Description

### Field of the Invention

The present invention relates to optical transmitters, and more precisely to manufacture of such optical transmitters.

### Background

In some technical domains, such as data center short reach optical links, one needs optical transmitters operating at very high bit rates, typically greater than 10 Gbit/s. To this effect, the optical transmitters generally comprise integrated Vertical Cavity Surface Emitting Lasers (or VCSELs). However, these VCSELs are limited in bandwidth and reach, and need to be cooled in order their optical component temperature of operation be stabilized. This cooling is generally performed by a ThermoElectric Cooler (or TEC) that is included in the optical module containing the optical transmitter, and which increases not only the power consumption by a large factor but also the dimensions and bulkiness of the optical module.

Some optical transmitters are able to work without cooling, but they comprise only discrete laser components that are limited to a single wavelength. Moreover they do not allow size reduction and/or cost reduction and/or power consumption reduction.

Advanced products for 4x10 Gbit/s uncooled transmitters on a CWDM ("Coarse Wavelength Division Multiplexing") grid have been also proposed in scientific literature. They are based on photonic integration technologies and could be able to support 4x25 Gbits/s. But they require very specific technology building blocks that are not available broadly and a huge investment in product development for component manufacturers.

Silicium-Photonics technology appears to be a promising technology due to its potential for cost reduction and integration with CMOS electronics. However no uncooled transmitter technology is presently available on any Silicium-Photonics platform.

### Summary

So an object of this invention is to improve the situation.

In an embodiment, a method is intended for manufacturing an optical transmitter comprising structures defining together transmission means, and comprises:
- a first step in which an InP (Indium Phosphide) wafer is bonded on a substrate comprising silicon, then this InP wafer is made thinner to become an InP buffer,
- a second step in which a dielectric mask is laid onto this InP buffer, then openings are patterned into chosen locations of this dielectric mask, and
- a third step in which the structures are grown into corresponding patterned openings, then remaining parts of the dielectric mask are removed.

This allows manufacturing optical transmitters operating at very high bit rates, typically greater than 10 Gbit/s, and that do not require any cooling.

The method may include additional characteristics considered separately or combined, and notably:
- in its third step the structures may be defined by Metal Organic Vapour Phase Epitaxy based Selective Area Growth (or MOVPE based SAG);
- in its first step the thickness of the InP buffer may be comprised between approximately 50 nm and approximately 5 µm;
- in its first step the InP wafer may be bonded on the substrate by means of a molecular bonding technique;
- in its first step the InP wafer may be made thinner by means of a technique chosen from a group comprising a chemical mechanical polishing, a special etch-stop layer chemical under-etch, and a peeling using hydrogen or helium ion implantation;
- in its first step the substrate may be chosen from a group comprising a silicon substrate and a silicon on insulator (or SOI) substrate;
- at least one of the structures may comprise a single quantum well or multiple quantum wells made with III/V semiconducting materials.

In an other embodiment, an optical transmitter comprises:
- a substrate comprising silicon,
- an InP buffer bonded on this substrate and resulting from a thinning of a bonded InP wafer, and
- structures defining transmission means together and grown on the InP buffer into corresponding openings previously patterned into chosen locations of a dielectric mask laid onto the InP buffer and finally removed.

For instance, this optical transmitter may comprise:
- a first structure defining a spot-size converter,
- a second structure defining a semiconductor optical amplifier and connected to an output of this spot-size converter,
- a third structure defining passive waveguides and connected to an output of this semiconductor optical amplifier,
- a fourth structure defining a multimode interference component and connected to an output of these passive waveguides,
- fifth structures defining passive waveguides and connected to an output of this multimode interference component, and
- sixth structures defining coarse wavelength division multiplexing emitters and connected respectively to outputs of these passive waveguides.

### Brief Description of the Figures

Some embodiments of a manufacturing method and an optical transmitter in accordance with embodiments of the present invention are now described, by way of example only, and with reference to the accompanying drawings, in which:
- Figures 1 to 6 schematically illustrate, in cross section views, an example of optical transmitter after implementation of six sub-steps of a manufacturing method according to the invention, and
- Figure 7 schematically illustrates, in a top view, an other example of embodiment of an optical transmitter according to the invention.

### Description of Embodiments

Hereafter is notably disclosed a method intended for manufacturing an optical transmitter 8 comprising structures 7ⱼ defining together transmission means.

One means here by "transmission means" any integrated passive or active means that can participate to the transmission of photons. So, it may be a spot-size converter, a semiconductor optical amplifier (or SOA), a waveguide, a multimode interference (or MMI) component, a modulator, a coarse wavelength division multiplexing emitter (or CWDM) that comprises a laser, or a series of lasers with a coupler that may be an arrayed waveguide grating (or AWG), or an echelle grating, or a MMI coupler, or cascading Y junctions, for instance.

A manufacturing method according to the invention comprises at least three steps. It starts from a substrate 1 comprising silicon. For instance, this substrate 1 may be a silicon substrate or a silicon on insulator (or SOI) substrate.

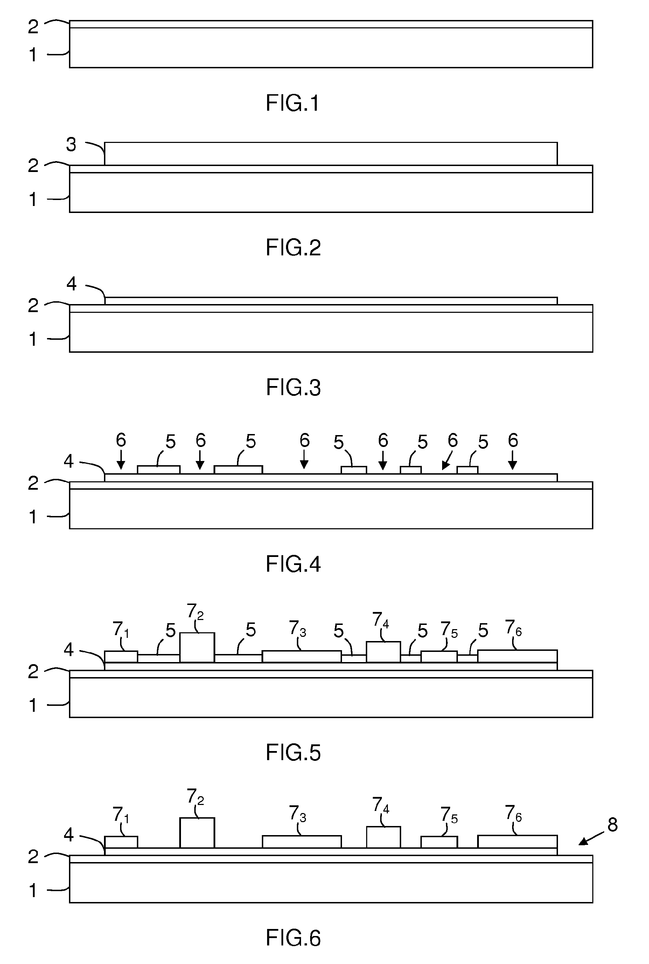

Preferably and as illustrated in Figure 1, the first step of the manufacturing method may comprise a preliminary and optional first sub step during which a bonding surface of the substrate 1 is prepared. For instance, this preparation may consist in formation of an oxydation layer 2.

During the first step an InP (Indium Phosphide) wafer 3 is bonded on the substrate 1. The result of this second sub step of the first step is illustrated in Figure 2. Any bonding technique known by those skilled in the art may be used, and notably a molecular bonding technique or a bonding by means of an adhesive layer, such as BCB (benzocyclobuten).

Then the InP wafer 3 is made thinner to become an InP buffer 4. The result of this third sub step of the first step is illustrated in Figure 3. The InP wafer 3 can be made thinner by any technique known by those skilled in the art, and notably by means of a chemical mechanical polishing, or a special etch-stop layer chemical under-etch, or else a peeling using hydrogen or helium ion implantation.

The thickness of the InP buffer 4 can be comprised between approximately 50 nm and approximately 5 µm. The choice of the thickness depends mainly from the type of coupling towards the optical waveguide, as known by those skilled in the art.

During a second step of the manufacturing method a dielectric mask 5 is laid onto the InP buffer 4, then openings 6 are patterned into chosen locations of this dielectric mask 5. These openings 6 are defined in locations where structures 7ⱼ defining transmission means must be defined. The result of (this fourth sub step of) the second step is illustrated in Figure 4.

For instance, the dielectric mask 5 may be made of SiO₂ material.

The openings 6 can be patterned into the dielectric mask 5 by any technique known by those skilled in the art, and notably by standard lithography and etching techniques.

During a third step of the manufacturing method the structures 7ⱼ (defining transmission means) are grown into corresponding patterned openings 6. The result of this fifth sub step of the third step is illustrated in Figure 5.

For instance, these structures 7ⱼ may be defined by Metal Organic Vapour Phase Epitaxy based Selective Area Growth (or MOVPE based SAG). Such a growth technique being well-known by those skilled in the art, it will not be described hereafter.

Preferably all the structures 7ⱼ are defined simultaneously in all the corresponding openings 6.

Also for instance, at least one of the structures 7ⱼ may comprise a single quantum well (or SQW) or multiple quantum wells (MQW) made with III/V semiconducting materials. For instance, each SQW or MQW can be made of InAlGaAs/InP or InGaAsP/InP or AllnGaAs/GaAs.

In the case where MOVPE based SAG technique is used, the opening pattern can be calculated in order to define islands during SAG growth on underlying InP buffer 4 bonded to silicon or SOI substrate 1, with III/V materials having different characteristic wavelength (notably when incorporated in laser waveguide structures). Indeed, a specific spatial distribution of material properties in different islands can be advantageously created by the SAG process when it occurs on a thin InP buffer bonded onto a silicon or SOI substrate.

Then, remaining parts of the dielectric mask 5 are removed to produce an optical transmitter 8. The result of this sixth sub step of the third step is illustrated in Figure 6. The manufactured optical transmitter 8 comprises a substrate 1 comprising silicon, an InP buffer 4 bonded on this substrate 1 and resulting from a thinning of a bonded InP wafer 3, and structures 7ⱼ defining transmission means together and grown on this InP buffer 4 into corresponding openings 6 previously patterned into chosen locations of a dielectric mask 5 laid onto the InP buffer 4 and finally removed.

The remaining parts of the dielectric mask 5 can be removed by any technique known by those skilled in the art, and notably by chemical products, or by wet chemical etching and/or plasma etching, or else by a combination of at least two of the preceding techniques.

The manufacturing method may further comprise a fourth step during which at least one structure 7ⱼ is individually connected to an external driving circuit, for instance via conductive tracks or by flip-chip bonding or else by any other means known by those skilled in the art.

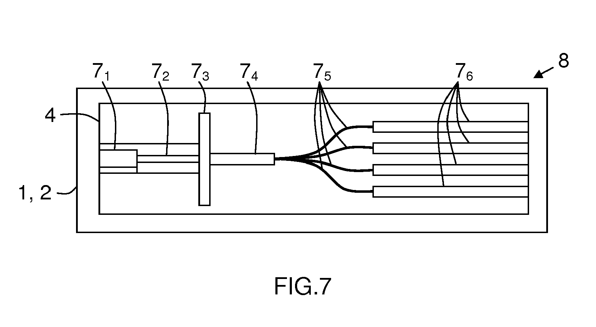

An example of an optical transmitter 8 manufactured by means of the method described above is schematically illustrated in Figure 7. In this non-limiting example, the optical transmitter 8 comprises seven types of structures 7ⱼ. A first structure 7₁ defines a spot-size converter intended for easing fiber coupling. A second structure 7₂ defines a semiconductor optical amplifier (or SOA) and is connected to an output of the spot-size converter 7₁. A third structure 7₃ defines passive waveguides and is connected to an output of the semiconductor optical amplifier 7₂. A fourth structure 7₄ defines a multimode interference (or MMI) component and is connected to an output of the passive waveguides 7₃. Fifth structures 7₅ define passive waveguides and are connected to an output of the multimode interference component 7₄. In the non-limiting example of Figure 7 four passive guides 7₅ are illustrated. Sixth structures 7₆ define coarse wavelength division multiplexing (CWDM) emitters and are connected respectively to outputs of the passive waveguides 7₅. In the non-limiting example of Figure 7 four CWDM emitters 7₆ are illustrated. It is important to note that the uncooled operation requires the four CWDM emitters 7₆ to have shifted wavelengths and therefore to be different one from the other.

It is important to note that the optical transmitter 8 described in the last paragraph is only an example. A lot of other combinations of structures 7ⱼ may be envisaged by those skilled in the art.

The invention allows manufacturing of optical transmitters operating at very high bit rates, typically greater than 10 Gbit/s, and that do not require any cooling. This allows CWDM transmission chips to be build on a Silicium-Photonics platform, notably for 100 Gbit/s / 400 Gbit/s Ethernet applications.

It should be appreciated by those skilled in the art that any block diagram herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Method for manufacturing an optical transmitter (8) comprising structures (7ⱼ) defining together transmission means, said method comprising a first step in which an InP wafer (3) is bonded on a substrate (1) comprising silicon, then said InP wafer (3) is made thinner to become an InP buffer (4), a second step in which a dielectric mask (5) is laid onto said InP buffer (4), then openings (6) are patterned into chosen locations of said dielectric mask (5), and a third step in which said structures (7ⱼ) are grown into corresponding patterned openings (6), then remaining parts of said dielectric mask (5) are removed.

2. Method according to claim 1, wherein in said third step said structures (7ⱼ) are defined by Metal Organic Vapour Phase Epitaxy based Selective Area Growth.

3. Method according to one of claims 1 and 2, wherein in said first step the thickness of said InP buffer (4) is comprised between approximately 50 nm and approximately 5 µm.

4. Method according to one of claims 1 to 3, wherein in said first step said InP wafer (3) is bonded on said substrate (1) by means of a molecular bonding technique.

5. Method according to one of claims 1 to 4, wherein in said first step said InP wafer (3) is made thinner by means of a technique chosen from a group comprising a chemical mechanical polishing, a special etch-stop layer chemical under-etch, and a peeling using hydrogen or helium ion implantation.

6. Method according to one of claims 1 to 5, wherein in said first step said substrate (1) is chosen from a group comprising a silicon substrate and a silicon on insulator substrate.

7. Method according to one of claims 1 to 6, wherein at least one of said structures (7ⱼ) comprises a single quantum well or multiple quantum wells made with III/V semiconducting materials.

8. Optical transmitter (8) comprising a substrate (1) comprising silicon, an InP buffer (4) bonded on said substrate (1) and resulting from a thinning of a bonded InP wafer (3), and structures (7ⱼ) defining transmission means together and grown on said InP buffer (4) into corresponding openings (6) previously patterned into chosen locations of a dielectric mask (5) laid onto said InP buffer (4) and finally removed.

9. Optical transmitter according to claim 8, wherein it comprises a first structure (7₁) defining a spot-size converter, a second structure (7₂) defining a semiconductor optical amplifier and connected to an output of said spot-size converter (7₁), a third structure (7₃) defining passive waveguides and connected to an output of said semiconductor optical amplifier (7₂), a fourth structure (7₄) defining a multimode interference component and connected to an output of said passive waveguides (7₃), fifth structures (7₅) defining passive waveguides and connected to an output of said multimode interference component (7₄), and sixth structures (7₆) defining coarse wavelength division multiplexing emitters and connected respectively to outputs of said passive waveguides (7₅).
